# EUROPEAN PATENT APPLICATION

(11) **EP 4 790 688 A1**
(43) Date of publication of application: **12.08.2026**
(21) Application number: 24874867.5
(22) Date of filing: 30.08.2024
(51) Int. Cl.: G09F 19/12, G09F 9/30, G06F 1/16, H10K 77/10, H10K 59/40, H10K 59/38, H10K 59/80, G09F 19/18, B60K 35/00

(54) **VEHICLE DISPLAY DEVICE AND OPERATING METHOD THEREOF**

(30) Priority: 06.10.2023 KR 20230133549
(71) Applicant: LG Electronics Inc., Yeongdeungpo-gu Seoul 07336 (KR)
(72) Inventor: KANG, Seungmo, Seoul 06772 (KR); KIM, Taeil, Seoul 06772 (KR); KIM, Hansoo, Seoul 06772 (KR); SHIM, Inkoo, Seoul 06772 (KR); DIBOINE, Romain, Seoul 06772 (KR)
(74) Representative: Vossius & Partner Patentanwälte Rechtsanwälte mbB
(86) International application number: PCT/KR2024/013061
(87) International publication number: WO 2025/075309

(57) **Abstract**

A vehicle display device is disclosed. The vehicle display device according to an embodiment of the present invention includes: a housing having a recessed inner space formed therein; a display disposed on one side of the inner space of the housing; a first reflection module coupled to one side of the display in the inner space and disposed to form a first screen region by refracting graphics emitted from a first region of the display; a second reflection module coupled to one side of the first reflection module in the inner space and disposed to form a second screen region by reflecting graphics emitted from a second region of the display; and a processor for controlling operations of the housing, the display, the first reflection module, and the second reflection module. Here, when the display is driven, the processor may control an operation of at least one of the first and second reflection module according to a configured condition to adjust activation of the first and second screen region, thereby implementing a plurality of different display driving modes by using only one display.

## Description

### Technical Field

The present disclosure relates to a vehicular display device. More particularly, the present disclosure relates to a vehicular display device formed to execute a plurality of display modes using graphic light emerging from a single display module.

### Background Art

A vehicle is an apparatus that transports a user in a direction desired by the user. A typical example of a vehicle is an automobile.

A trend has emerged in which vehicles are equipped with various sensors, electronic devices, and equivalents thereof to improve user convenience. Particularly, to enhance user convenience, extensive research has been conducted on Advanced Driver Assistance Systems (ADAS). Furthermore, the development of autonomous vehicles has been actively conducted.

The term 'autonomous driving' refers to a system in which a vehicle is capable of determining driving behavior and operating without input from an occupant. This autonomous driving may be categorized into progressive stages ranging from non-automation to full automation, depending on the degree to which the system is involved in driving and the extent to which a driver controls a vehicle.

Autonomous driving of vehicles has transformed the perception of vehicles from being merely a means of transportation to being a space where one can dwell. Moreover, a trend has emerged in which displays of ever-increasing size are mounted in vehicles to allow users to enjoy various infotainment content. In addition, research and development have been conducted to provide a more diverse usage environment when using the display.

### Disclosure of Invention

### Technical Problem

The objects of the present disclosure are to address the above-mentioned problems and other related problems.

According to some embodiments of the present disclosure, one object of the present disclosure is to provide a vehicular display device capable of providing a plurality of usage environments using a single display, and a method of operating the vehicular display device.

According to some embodiments of the present disclosure, another object of the present disclosure is to provide a vehicular display device capable of using, selectively or simultaneously, different types of usage environments formed through a single display, and a method of operating the vehicular display device.

According to some embodiments of the present disclosure, a further object of the present disclosure is to provide a vehicular display device capable of varying a position at which a 3D graphic floats according to a user's field of view, a content type, or content movement, and a method of operating the vehicular display device.

### Solution to Problem

To accomplish the above-mentioned objects and other related objects, a vehicular display device according to an embodiment of the present disclosure refracts or reflects graphic light emerging from one display through different reflective modules, or forms one reflective module and a form factor in one region in a varied manner, thereby executing various display modes using a single display module.

According to one aspect of the present disclosure, there is provided a vehicular display device including: a housing recessed to form an inner space inside; a display arranged on one side of the inner space in the housing; a first reflective module coupled to one side of the display in the inner space and arranged in such a manner that graphic light emitted from a first region of the display forms a first screen region after refraction; a second reflective module coupled to one side of the first reflective module in the inner space and arranged in such a manner that graphic light emitted from a second region of the display forms a second screen region after reflection; and a processor arranged on the other side of the inner space and coupled to the display, the first reflective module, and the second reflective module, thereby controlling each operation thereof. In the vehicular display device, when operating the display, the processor controls the operation of at least one of the first and second reflective modules according to a preset condition, thereby determining whether to activate the first and second screen regions.

In an embodiment, in the vehicular display device, the first screen region may be a prism region, and the second region may be an AR floating region that is connected to the first screen region and in which an AR image is displayed in the inner space.

In an embodiment, in the vehicular display device, the preset condition may be associated with a vehicle driving state, the processor may receive, from the vehicle, information related to the vehicle driving state and may activate the first reflective module according to the received information while a vehicle is in a first driving state, thereby displaying a driving situation on the prism region, and, when the vehicle switches to a second driving state according to the received information, the processor may control the first and second reflective modules by activating both the first and second reflective modules in such a manner that the driving situation is displayed together in the prism region and the AR floating region.

In an embodiment, in the vehicular display device, the processor may activate the second reflective module according to the received information while the vehicle is in a third driving state, and may control the second reflective module in such a manner that a virtual image is displayed in the second screen region and that a graphic object related to the virtual image is displayed in the first screen region.

In an embodiment, in the vehicular display device, the display may be arranged in an upper inner portion of the inner space in the housing in such a manner as to face the ground and may be formed to have a structure configured with a slope non-parallel with the ground.

In an embodiment, in the vehicular display device, the first reflective module may include a prism arranged in an upper portion in such a manner as to extend to the first region of the display, and the second reflective module may include a 3D plate that extends from one side of the prism and is arranged to face the second region of the display. In the vehicular display device, in a state where the first reflective module is activated, the processor may control the prism in such a manner as to refract linearly polarized light corresponding to a graphic on the first region, thereby forming the first screen region, and, in a state where the second reflective module is activated, the processor may control the 3D plate in such a manner as to reflect linearly polarized light corresponding to a graphic on the second region, thereby forming the second screen region in which a 3D virtual (AR) image is displayed.

In an embodiment, in the vehicular display device, the first screen region may be formed over the second screen region in such a manner as to extend to the first region of the display, the second screen region may be formed under the first screen region, and AR content to be displayed in the second screen region may be formed within the inner space in the housing or may be formed to extend outward from the inner space.

In an embodiment, the vehicular display device may further include: a UTG plate coupled to a rear surface of the 3D plate; and a light absorption plate adjacent to the 3D plate and absorbing linearly polarized light that is not reflected by the 3D plate.

In an embodiment, in the vehicular display device, the first reflective module may be fixed to be adjacent to the first region of the display, and one side of the second reflective module may be fixed to be adjacent to the first reflective module and may be formed in such a manner that a separation distance from the display progressively increases from one side toward the other side thereof and that an inclination angle between the second reflective module and the display is adjustable. In the vehicular display device, the processor may be arranged on a rear surface of the inner space in the housing and may adjust the rotation of the second reflective module in such a manner that the inclination angle between the second reflective module and the display is adjusted.

In an embodiment, in the vehicular display device, the processor may adjust the rotation of the second reflective module, thereby adjusting the inclination angle, and thus may control the second screen region in such a manner that a position thereof moves backward or forward with respect to the inner space in the housing.

In an embodiment, in the vehicular display device, the processor may adjust the rotation of the second reflective module based on field-of-view information of an occupant detected by an IMS sensor of a vehicle in such a manner that the position of the second screen region is varied.

In an embodiment, in the vehicular display device, the processor may display a first graphic image in the first screen region through the first reflective module, and, based on movement of a virtual second graphic image displayed in the first screen region through the second reflective module, may adjust the rotation of the second reflective module in such a manner that the position of the second screen region is adaptively varied.

In an embodiment, in the vehicular display device, the housing may further include: a front cover formed in such a manner that the inner space, formed by recessing the housing, is rotatable, and driven according to whether the display is in operation, in such a manner that the inner space is closed or exposed.

According to another aspect of the present disclosure, there is provided a vehicular display device including: a housing recessed to form an inner space inside; a display positioned in an inner space in the housing; a reflective module coupled adjacent to the display and arranged in such a manner that graphic light emitted from the display forms a virtual screen region within the inner space after refraction; a drive module arranged on a rear surface of one region of the display in such a manner that one portion of the display is bent out, thereby forming a form-variable display region; and a processor electrically connected to the display, the reflective module, and the drive module and controlling each operation thereof. In the vehicular display device, when operating the display, the processor may control the operation of at least one of the reflective and drive modules according to a preset condition, thereby determining whether to activate the virtual screen region and the form-variable display region.

### Advantageous Effects of Invention

A vehicular display device according to an embodiment of the present disclosure can execute a plurality of different display modes selectively or simultaneously using a single display module. For example, a real image or an aerial image may be displayed selectively or simultaneously using only a single display.

In addition, the vehicular display device according to an embodiment of the present disclosure can vary a position of a 3D virtual image that floats according to a content type or content movement, based on a user's field of view, thereby displaying a graphic image in such a manner that the 3D virtual image falls within the user's field of view and that a sense of immersion and a floating effect are maximized.

### Brief Description of Drawings

FIGS. 1 and 2 are block diagrams that are referenced to describe the configuration of a vehicle according to the present disclosure.
FIG. 3 is a view illustrating an example in which a vehicular display device according to the present disclosure operates after installation.
FIG. 4 is an exemplary block diagram that is referenced to describe the detailed configuration of the vehicular display device according to the present disclosure.
FIG. 5 is a perspective view illustrating the vehicular display device according to the present disclosure.
FIG. 6 is a cross-sectional view illustrating a state where a prism display region and a floating display region are formed when the vehicular display device according to the present disclosure operates, when viewed from the side.
FIG. 7 is an exemplary view that is referenced to describe a plurality of display regions in accordance with a display mode of the vehicular display device according to the present disclosure.
FIG. 8 is a view illustrating the vehicular display device arranged in a cluster or CID region of the vehicle according to the present disclosure, when viewed from the side.
FIG. 9 is an exemplary flowchart that is referenced to describe a method of operating the vehicular display device according to the present disclosure.
FIGS. 10, 11, and 12 are views illustrating exemplary structures of the vehicular display device, respectively, for executing a plurality of display modes using a single display, according to the present disclosure.
FIG. 13 is a set of conceptual views that is referenced to describe a method of changing a position of an AR image in a floating display region in the vehicular display device according to the present disclosure.
FIG. 14 is a view illustrating a vehicular display device according to another embodiment of the present disclosure.
FIGS. 15 to 17 are exemplary conceptual views that are referenced to describe the operation of the vehicular display device according to the embodiment of the present disclosure, which includes a floating display region and a variable display region.

### Mode for the Invention

Embodiments disclosed in the present specification will be described in detail below with reference to the accompanying drawings. The same reference numerals are used for the same or similar constituent elements, regardless of figure numbers, and redundant descriptions thereof are not repeated. The terms 'module' and 'unit' are hereinafter used interchangeably to name constituent elements solely for the convenience of description in the present specification. These terms are not intended to have different meanings or to indicate different functions. In addition, in describing the embodiments disclosed in the present specification, detailed descriptions of well-known related technologies may be omitted when such descriptions are deemed to obscure the nature and gist of the present disclosure. In addition, the accompanying drawings are merely provided to facilitate understanding of the embodiments disclosed in the present specification and shall not be construed as limiting the technical idea disclosed in the present specification. Furthermore, any modifications, equivalents, or substitutions of constituent elements, to the extent falling within the technical scope of the present disclosure, are intended to be encompassed within the scope of the present disclosure.

The ordinal numbers first, second, and so forth may be used to describe various elements, but they do not limit these elements. These terms are used merely to distinguish among constituent elements having similar functions.

It should be understood that a constituent element, when referred to as 'being connected to' or 'having access to' a different constituent element, may be directly connected to or have direct access to the different constituent element, or may be indirectly connected to or have access to the different constituent element through one or more intermediate constituent elements. Likewise, it should be understood that, when a constituent element is described as being 'connected to' or 'having access to' another constituent element, such connection or access may be direct without the need for one or more intermediary constituent elements.

A noun in singular form, unless clearly indicated otherwise by the context, shall be understood to include the plural form.

The terms 'include,' 'have,' and equivalent expressions, as used in the present application, shall be understood to indicate the presence of a feature, number, step, operation, constituent element, component, or combination thereof, without precluding the possibility of the presence or addition of one or more other features, numbers, steps, operations, constituent elements, components, or combinations thereof.

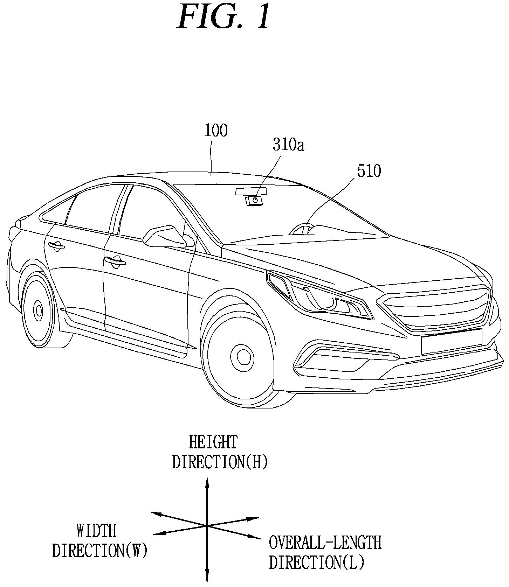

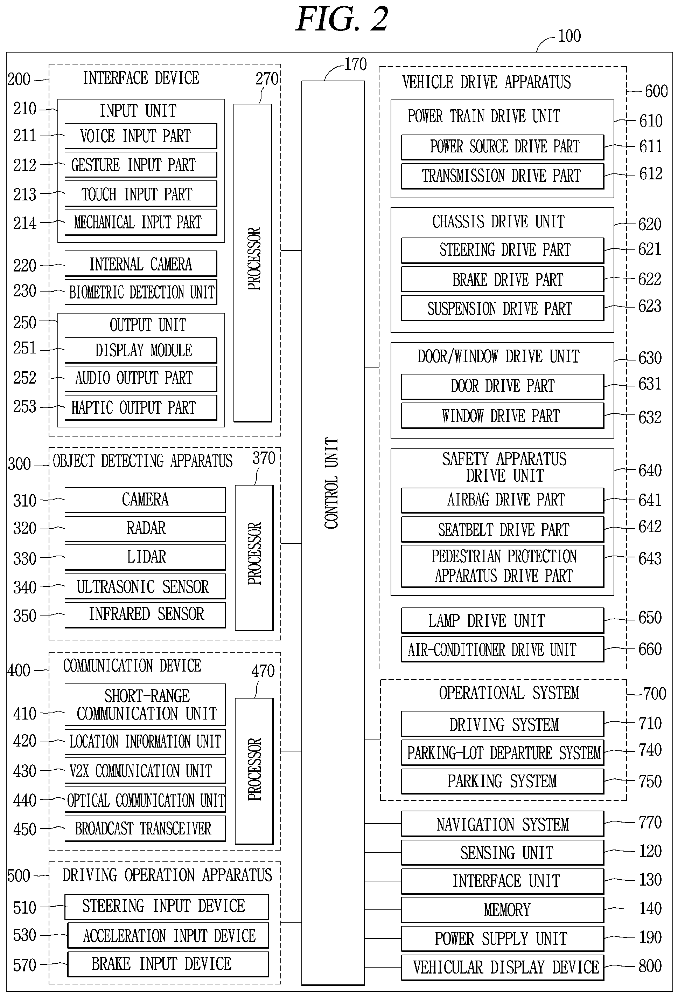

FIGS. 1 and 2 are exemplary block diagrams that are referenced to describe a vehicle according to the present disclosure and the configuration of the vehicle.

With reference to FIG. 1, a vehicle 100 may include wheels that are rotated by a power source and a steering input device 510 for adjusting the traveling direction of the vehicle 100.

The vehicle 100 may be an autonomous driving vehicle. The vehicle 100 may switch to an autonomous driving mode or a manual mode in response to a user input. For example, the vehicle 100 may switch from the manual mode to the autonomous driving mode or from the autonomous driving mode to the manual mode in response to the user input received through a user interface device 200 (hereinafter referred to as a 'user terminal').

The vehicle 100 may switch to the autonomous driving mode or the manual mode on the basis of driving situation information. The driving situation information may be generated on the basis of object information provided by an object detection device 300. For example, the vehicle 100 may switch from the manual mode to the autonomous driving mode or from the autonomous driving mode to the manual mode on the basis of the driving situation information generated by the object detection device 300. For example, the vehicle 100 may switch from the manual mode to the autonomous driving mode or from the autonomous driving mode to the manual mode on the basis of the driving situation information received through a communication device 400.

The vehicle 100 may switch from the manual mode to the autonomous driving mode or from the autonomous driving mode to the manual mode on the basis of information, data, or signals, each of which is provided by an external device.

In a case where the vehicle 100, which is an autonomous driving vehicle, may be driven in the autonomous driving mode, the vehicle 100 may be driven through the use of an operational system 700. For example, the autonomous driving vehicle 100 may be driven on the basis of information, data, or signals, each of which is generated by a driving system 710, a parking-lot departure system 740, or a parking system 750.

In a case where the vehicle 100, which is an autonomous driving vehicle, is driven in the manual mode, the vehicle 100 may receive a user input for driving through a driving operation apparatus 500. The vehicle 100 may be driven in response to the user input received through the driving operation apparatus 500.

The vehicle 100 may include the user interface device 200, the object detection devices 300, the communication device 400, the driving operation apparatus 500, a vehicle driving apparatus 600, the operational system 700, a navigation system 770, a sensing unit 120, a vehicular interface unit 130, a memory 140, a control unit 170, and a power supply unit 190.

According to an embodiment, the vehicle 100 may further include one or more constituent elements in addition to the constituent elements described in the present specification or may omit one or more of the described constituent elements.

The user interface device 200 is a device for communication between the vehicle 100 and the user. The user interface device 200 may receive the user input and may provide information, generated by the vehicle 100, to the user. The vehicle 100 may provide a user interface (UI) or user experience (UX) through the user interface device (hereinafter referred to as the 'user terminal') 200.

The user interface device 200 may include an input unit 210, an internal camera 220, a biometric detection unit 230, an output unit 250, and a processor 270. According to an embodiment, the user interface device 200 may further include one or more constituent elements in addition to the constituent elements described in the present specification or may omit one or more of the described constituent elements.

The input unit 210 serves to receive information as input from the user. The processor 270 may analyze data collected through the input unit 210 and may convert the data into a control command of the user.

The input unit 210 may be arranged within the vehicle 100. For example, the input unit 210 may be arranged in a region of the steering wheel, a region of the instrument panel, a region of the seat, a region of each pillar, a region of the door, a region of the center console, a region of the headlining, a region of the sun visor, a region of the windshield, a region of the window, or a region of a similar location.

The input unit 210 may include a voice input part 211, a gesture input part 212, a touch input part 213, and a mechanical input part 214.

The voice input part 211 may convert a user's voice input into an electrical signal. The electrical signal, resulting from the conversion, may be provided to the processor 270 or the control unit 170. The voice input part 211 may include one or more microphones.

The gesture input part 212 may convert a user's gesture input into an electrical signal. The electrical signal, resulting from the conversion, may be provided to the processor 270 or the control unit 170.

The gesture input part 212 may include at least one of the following: an infrared sensor or an image sensor, each of which serves to detect the user's gesture input. According to an embodiment, the gesture input part 212 may detect a user's three-dimensional (3D) gesture input. To this end, the gesture input part 212 may include a plurality of light-emitting units, each emitting an infrared ray, or a plurality of image sensors.

The gesture input part 212 may detect the user's 3D gesture input through a time-of-flight (TOF) technique, a structured light technique, or a disparity technique.

The touch input part 213 may convert the user's touch input into an electrical signal. The electrical signal, resulting from the conversion, may be provided to the processor 270 or the control unit 170.

The touch input part 213 may include a touch sensor for detecting the user's touch input. According to an embodiment, the touch input part 213 may be integrally formed with a display part 251, thereby forming a touch screen. The touch screen may provide both an input interface and an output interface between the vehicle 100 and the user.

The mechanical input part 214 may include at least one of the following: a button, a dome switch, a jog wheel, or a jog switch. An electrical signal generated by the mechanical input part 214 may be provided to the processor 270 or the control unit 170. The mechanical input part 214 may be arranged on a steering wheel, a center fascia, a center console, a cockpit module, a door, or an equivalent thereof.

The internal camera 220 may acquire an image of the interior of the vehicle 100. The processor 270 may detect the user's state on the basis of the image of the interior of the vehicle 100. The processor 270 may acquire the user's gaze information from the image of the interior of the vehicle 100. The processor 270 may detect the user's gesture from the image of the interior of the vehicle 100.

The biometric detection unit 230 may acquire the user's biometric information. The biometric detection unit 230 may include a sensor for acquiring the user's biometric information and may acquire the user's fingerprint information, heart rate information, and equivalents thereof using the sensor. The biometric information may be used for user authentication.

The output unit 250 may generate outputs associated with a visual sense, an auditory sense, a haptic sense, and the like. The output unit 250 may include at least one of the following: a display unit, an audio output unit 252, and a haptic output unit 253.

The display unit may display graphic objects that correspond to various pieces of information. The display module may include at least one of the following: a liquid crystal display (LCD), a thin-film transistor-LCD (TFT LCD), an organic light-emitting diode (OLED), a flexible display, a three-dimensional (3D) display, or an e-ink display.

The display unit may be configured to have a layered structure or an integrated structure with the touch input unit 213, thereby forming a touch screen.

The display unit may be configured as a head-up display (HUD). In a case where the display unit is configured as a HUD, the display unit may include a projection module, thereby outputting information through an image projected onto a windshield or a window.

The display unit may include a transparent display. The transparent display may be attached to the windshield or the window. The transparent display may have a predetermined degree of transparency and may output a predetermined screen thereon. To exhibit a degree of transparency, the transparent display may include at least one of the following: a thin-film electroluminescent (TFEL), a transparent organic light-emitting diode (OLED), a transparent liquid crystal display (LCD), a transmissive transparent display, or a transparent light-emitting diode (LED) display. The transparent display may have an adjustable level of transparency.

The user interface device 200 may include a plurality of display units. In this case, the plurality of display units may be positioned in various regions of the vehicle.

The audio output part 252 converts an electrical signal, provided from the processor 270 or the control unit 170, into an audio signal and outputs the audio signal. To this end, the audio output part 252 may include at least one speaker.

The haptic output part 253 generates a tactile output. For example, the haptic output unit 253 vibrates the steering wheel, the safety belt, or the seat, thereby enabling the user to perceive the tactile output.

The processor (hereinafter referred to as a 'control unit') 270 may control the overall operation of each unit of the user interface device 200. That is, the user interface device 200 may operate under the control of the control unit 170.

According to an embodiment, the user interface device 200 may include a plurality of processors 270 or may be configured without the processor 270.

In a case where the processor 270 is not included in the user interface device 200, the user interface device 200 may operate under the control of a processor of another apparatus within the vehicle 100, or under the control of the control unit 170.

The object detection device 300 is a device for detecting an object located outside the vehicle 100. This object may be an external entity associated with the driving of the vehicle 100. Examples of such an object include a lane, another vehicle, a pedestrian, a two-wheeled vehicle, a traffic signal, ambient light, a road, a structure, a speed bump, a terrain feature, an animal, and equivalents thereof.

The objects may be classified into movable objects and stationary objects. Examples of the movable objects may be conceptually represented as including another vehicle and a pedestrian. Examples of the stationary objects may be conceptually represented as including a traffic light, a road, and a structure.

The object detection device 300 may include a camera 310, a radar 320, a LiDAR 330, an ultrasonic sensor 340, an infrared sensor 350, and a processor 370.

According to an embodiment, the object detection device 300 may further include one or more constituent elements in addition to the constituent elements described in the present specification or may omit one or more of the described constituent elements.

The camera 310 may be located on an appropriate portion of the exterior of the vehicle to capture an image of the surroundings of the vehicle 100. The camera 310 may be a mono camera, a stereo camera 310a, an around-view monitoring (AVM) camera 310b, or a 360-degree camera.

For example, the camera 310 may be arranged adjacent to a front windshield within the vehicle to acquire an image of the surroundings in front of the vehicle. Alternatively, the camera 310 may be arranged in the vicinity of the front bumper or the radiator grill.

For example, the camera 310 may be arranged adjacent to a rear glass pane within the vehicle to capture the image of the surroundings behind the vehicle. Alternatively, the camera 310 may be arranged adjacent to a rear bumper, a trunk, or a tailgate.

For example, the camera 310 may be arranged adjacent to at least one of the side windows within the vehicle to capture an image of the surroundings alongside the vehicle. Alternatively, the camera 310 may be arranged in the vicinity of a side mirror, a fender, or a door.

The camera 310 may provide an acquired image to the processor 370.

The radar 320 may include an electromagnetic wave transmission unit and an electromagnetic wave reception unit. The radar 320 may be configured based on a pulse radar method or a continuous wave radar method, in accordance with the principle of emitting a radio wave. The radar 320 may be configured based on a Frequency Modulated Continuous Wave (FMCW) method or a Frequency Shift Keying (FSK) method, each of which is among continuous wave radar methods determined according to the signal waveform.

The radar 320 may detect an object based on a time-of-flight (TOF) technique or a phase-shift technique through the use of electromagnetic waves and may determine the location of the object, the distance to the object, and the relative speed with respect to the object.

The radar 320 may be arranged in an appropriate position on the exterior of the vehicle 100 to detect an object that is located in front of, behind, or alongside the vehicle 100.

The LiDAR 330 may include a laser transmission unit and a laser reception unit. The LiDAR 330 may be configured based on the time-of-flight (TOF) technique or the phase-shift technique.

The LiDAR 330 may be configured as a drive-type or non-drive-type LiDAR.

In a case where the LiDAR 330 may be configured as a drive-type LiDAR, the LiDAR 330 may be rotated by a motor and may detect an object in the vicinity of the vehicle 100.

In a case where the LiDAR 330 may be configured as a non-drive-type LiDAR, the LiDAR 330 may detect, through light steering, an object located within a predetermined range of the vehicle 100. The vehicle 100 may include a plurality of non-drive-type LiDAR's 330.

The LiDAR 330 may detect an object based on the time-of-flight (TOF) technique or the phase-shift technique through the use of laser light and may determine the location of the object, the distance to the object, and the relative speed with respect to the object.

The radar 330 may be arranged at an appropriate position on the exterior of the vehicle 100 to detect an object that is located in front of, behind, or alongside the vehicle 100.

The ultrasonic sensor 340 may include an ultrasonic wave transmission unit and an ultrasonic wave reception unit. The ultrasonic sensor 340 may detect an object through the use of ultrasonic waves and may determine the location of the object, the distance to the object, and the relative speed with respect to the object.

The ultrasonic sensor 340 may be arranged at an appropriate position on the exterior of the vehicle 100 to detect an object located in front of, behind, or alongside the vehicle 100.

The infrared sensor 350 may include an infrared light transmission unit and an infrared light reception unit. The infrared sensor 340 may detect an object through the use of infrared light and may determine the location of the detected object, the distance to the detected object, and the relative speed with respect to the detected object.

The infrared sensor 350 may be arranged at an appropriate position on the exterior of the vehicle 100 to detect an object located in front of, behind, or alongside the vehicle 100.

The processor 370 may control the overall operation of each unit of the object detection device 300.

The processor 370 may detect and track an object on the basis of an acquired image. The processor 370 may perform operations, such as calculation of the distance to the object and calculation of the relative speed with respect to the object, through the use of an image processing algorithm.

The processor 370 may detect and track an object through the use of reflected electromagnetic waves, resulting from the reflection of emitted electromagnetic waves by the object. The processor 370 may perform operations, such as calculation of the distance to the object and calculation of the relative speed with respect to the object, through the use of electromagnetic waves.

The processor 370 may detect and track an object through the use of reflected laser beams, resulting from the reflection of emitted lasers by the object. The processor 370 may perform operations, such as calculation of the distance to the object and calculation of the relative speed with respect to the object, through the use of laser beams.

The processor 370 may detect and track an object through the use of reflected ultrasonic waves, resulting from the reflection of emitted ultrasonic waves by the object. The processor 370 may perform operations, such as calculation of the distance to the object and calculation of the relative speed with respect to the object, through the use of ultrasonic waves.

The processor 370 may detect and track an object through the use of reflected infrared light, resulting from the reflection of emitted infrared light by the object. The processor 370 may perform operations, such as calculation of the distance to the object and calculation of the relative speed with respect to the object, through the use of infrared light.

According to an embodiment, the object detection device 300 may include a plurality of processors 370 or may be configured without including the processor 370. The camera 310, the radar 320, the LiDAR 330, the ultrasonic sensor 340, and the infrared sensor 350 may include respective processors for individual operation.

In a case where the processor 370 is not included in the object detection device 300, the object detection device 300 may operate under the control of a processor of an apparatus within the vehicle 100, or under the control of the control unit 170.

The object detection device 300 may operate under the control of the control unit 170.

The communication device 400 is a device for performing communication with an external device. The external device here may be another vehicle, a mobile terminal, or a server.

To perform communication, the communication device 400 may include a transmission antenna, a reception antenna, and at least one of the following: a radio frequency (RF) circuit or an RF device, each of which is capable of implementing various communication protocols.

The communication device 400 may include a short-range communication unit 410, a location information unit 420, a V2X communication unit 430, an optical communication unit 440, a broadcast transceiver 450, and a processor 470.

According to an embodiment, the communication device 400 may further include one or more constituent elements in addition to the constituent elements in the present specification or may omit one or more of the described constituent elements.

The short-range communication unit 410 is a unit for short-range communication. The short-range communication unit 410 may support short-range communication using at least one of the following technologies: Bluetooth^{™}, Radio Frequency IDentification (RFID), Infrared Data Association (IrDA), Ultra-Wide Band (UWB), Zig Bee, Near Field Communication (NFC), Wireless-Fidelity (Wi-Fi), Wi-Fi Direct, or Wireless Universal Serial Bus (USB).

The short-range communication unit 410 may form short-range wireless area networks and may perform short-range communication between the vehicle 100 and at least one external device.

The location information unit 420 is a unit for acquiring location information of the vehicle 100. For example, the location information unit 420 may include a Global Positioning System (GPS) module or a Differential Global Positioning System (DGPS) module.

The V2X communication unit 430 is a unit for performing wireless communication with a server (Vehicle to Infrastructure (V2I)), with another vehicle (Vehicle to Vehicle (V2V)), or with a pedestrian (Vehicle to Pedestrian (V2P)). The V2X communication unit 430 may include an RF circuit capable of implementing protocols for communication with an infrastructure (V2I), communication between vehicles (V2V), and communication with a pedestrian (V2P).

The optical communication unit 440 is a unit for performing communication with the external device through the use of light. The optical communication unit 440 may include an optical transmission part for converting an electrical signal into an optical signal and transmitting the optical signal to the outside, and an optical reception part for converting a received optical signal into an electrical signal.

According to an embodiment, the optical transmission part may be integrally formed with a lamp included in the vehicle 100.

The broadcast transceiver 450 is a unit for receiving a broadcast signal from an external broadcast management server or transmitting a broadcast signal to the broadcast management server over a broadcast channel. The broadcast channel may refer to a satellite channel, a terrestrial channel, or both. The broadcast signal may include a TV broadcast signal, a radio broadcast signal, and a data broadcast signal.

The processor 470 may control the overall operation of each unit of the communication device 400.

According to an embodiment, the communication device 400 may include a plurality of processors 470 or may be configured without including the processor 470.

In a case where the processor 470 is not included in the communication device 400, the communication device 400 may operate under the control of a processor of another apparatus within the vehicle 100, or under the control of the control unit 170.

The communication device 400, together with the user interface device 200, may constitute a vehicular display device. In this case, the vehicular display device may be referred to as a telematics device or an Audio Video Navigation (AVN) device.

The communication device 400 may operate under the control of the control unit 170.

The driving operation apparatus 500 is an apparatus that receives a user input for driving.

In the manual mode, the vehicle 100 may be driven on the basis of a signal provided by the driving operation apparatus 500.

The driving operation apparatus 500 may include the steering input device 510, an acceleration input device 530, and a brake input device 570.

The steering input device 510 may receive an input regarding the traveling direction of the vehicle 100 from the user. The steering input device 510 is preferably formed in the form of a wheel, thereby enabling a steering input through the rotation of the wheel. According to an embodiment, the steering input device may also be formed in the shape of a touch screen, a touchpad, or a button.

The acceleration input device 530 may receive, from the user, an input for accelerating the vehicle 100. The brake input device 570 may receive, from the user, an input for decelerating the vehicle 100. The acceleration input device 530 and the brake input device 570 are preferably formed in the shape of a pedal. According to an embodiment, the acceleration input device or the brake input device may also be formed in the shape of a touch screen, a touchpad, or a button.

The driving operation apparatus 500 may operate under the control of the control unit 170.

The vehicle drive apparatus 600 is an apparatus that electrically controls the operation of various apparatuses within the vehicle 100.

The vehicle drive apparatus 600 may include a power train drive unit 610, a chassis drive unit 620, a door/window drive unit 630, a safety apparatus drive unit 640, a lamp drive unit 650, and an air-conditioner drive unit 660.

According to an embodiment, the vehicle drive apparatus 600 may further include one or more constituent elements in addition to the constituent elements described in the present specification or may omit one or more of the described constituent elements.

The vehicle drive apparatus 600 may include a processor. Units of the vehicle drive apparatus 600 may include respective processors for individual operation.

The power train drive unit 610 may control the operation of a power train apparatus.

The power train drive unit 610 may include a power source drive part 611 and a transmission drive part 612.

The power source drive part 611 may execute control of a power source of the vehicle 100.

For example, in a case where the power source of the vehicle is a fossil-fuel-based engine, the power source drive part 610 may execute electronic control of the engine. Accordingly, output torque and other parameters of the engine may be controlled. The power source drive part 611 may adjust the engine output torque under the control of the control unit 170.

For example, in a case where the power source of the vehicle is an electric-energy-based motor, the power source drive part 610 may execute control of the motor. The power source drive part 610 may adjust the rotational speed, torque, and other parameters of the motor under the control of the control unit 170.

The transmission drive part 612 may execute control of a transmission. The transmission drive gearbox part 612 may adjust the state of the transmission. The transmission drive part 612 may change the state of the transmission to Drive (D), Reverse (R), Neutral (N), or Park (P).

In a case where the power source of the vehicle is an engine, the transmission drive part 612 may adjust the engaged state of a gear in Drive (D).

The chassis drive unit 620 may control the operation of a chassis apparatus. The chassis drive unit 620 may include a steering drive part 621, a brake drive part 622, and a suspension drive part 623.

The steering drive part 621 may execute electronic control of a steering apparatus within the vehicle 100. The steering drive part 621 may change the traveling direction of the vehicle.

The brake drive part 622 may execute electronic control of a brake apparatus within the vehicle 100. For example, the brake drive part 622 may reduce the speed of the vehicle 100 by controlling the operation of the brakes provided on the wheels.

The brake drive part 622 may individually control each of the plurality of brakes. The brake drive part 622 may control the application of varying braking forces to the plurality of wheels.

The suspension drive part 623 may execute electronic control of a suspension apparatus within the vehicle 100. For example, in a case where a road surface is uneven, the suspension drive part 623 may reduce vibration of the vehicle 100 by controlling the suspension apparatus. The suspension drive part 623 may control each of the plurality of suspensions individually.

The door/window drive unit 630 may execute electronic control of a door apparatus or a window apparatus within the vehicle 100.

The door/window drive unit 630 may include a door drive part 631 and a window drive part 632.

The door drive part 631 may execute control of the door apparatus. The door drive part 631 may control the opening or closing of a plurality of doors included in the vehicle 100. The door drive part 631 may control the opening or closing of the trunk or the tailgate. The door drive part 631 may control the opening or closing of the sunroof.

The window drive part 632 may execute electronic control of the window apparatus. The window drive part 632 may control the opening or closing of a plurality of windows included in the vehicle 100.

The safety apparatus drive unit 640 may execute electronic control of various safety apparatuses within the vehicle 100.

The safety apparatus drive unit 640 may include an airbag drive part 641, a seat belt drive part 642, and a pedestrian protection apparatus drive part 643.

The airbag drive part 641 may execute electronic control of an airbag apparatus within the vehicle 100. For example, when a risk is detected, the airbag drive part 641 may control an airbag in such a manner that the airbag is deployed.

The seat belt drive part 642 may execute electronic control of a seat belt apparatus within the vehicle 100. For example, when a risk is detected, the seat belt drive part 642 may secure occupants seated in seats 110FL, 110FR, 110RL, and 110RR by tightening respective seat belts.

The pedestrian protection apparatus drive part 643 may execute electronic control of the hood lift and the pedestrian airbag. For example, when a collision with a pedestrian is detected, the pedestrian protection apparatus drive part 643 may control a hood and the pedestrian airbag in such a manner that the hood is lifted up and that the pedestrian airbag is deployed.

The lamp drive part 650 may execute electronic control of various lamp apparatuses within the vehicle 100.

The air-conditioner drive unit 660 may execute electronic control of an air conditioner within the vehicle 100. For example, when the temperature inside the vehicle 100 is high, the air-conditioner drive unit 660 may control the air conditioner to operate in such a manner as to supply cool air into the vehicle 100.

The vehicle drive apparatus 600 may include a processor. Units of the vehicle drive apparatus 600 may include respective processors for individual operation.

The vehicle drive apparatus 600 may operate under the control of the control unit 170.

The operational system 700 is a system that controls various driving functions of the vehicle 100. The operational system 700 may operate in the autonomous driving mode.

The operational system 700 may include the driving system 710, the parking-lot departure system 740, and the parking system 750.

According to an embodiment, the operational system 700 may further include one or more constituent elements in addition to the constituent elements described in the present disclosure or may omit one or more of the described constituent elements.

The operational system 700 may include a processor. Units of the operational system 700 may include respective processors for individual operation.

According to an embodiment, in a case where the operational system 700 may be implemented in software, the operational system 700 may also conceptually operate at a lower level than the control unit 170.

According to an embodiment, the operational system 700 may conceptually include at least one of the following: the user interface device 200, the object detection device 300, the communication device 400, the vehicle drive apparatus 600, or the control unit 170.

The driving system 710 may enable the vehicle 100 to be driven.

The driving system 710 may receive navigation information from the navigation system 770, may provide a control signal to the vehicle drive apparatus 600, and may enable the vehicle 100 to be driven. The driving system 710 may receive object information from the object detection device 300, may provide a control signal to the vehicle drive apparatus 600, and may enable the vehicle 100 to be driven. The driving system 710 may receive a signal from an external device through the communication device 400, may provide a control signal to the vehicle drive apparatus 600, and may enable the vehicle 100 to be driven.

The parking-lot departure system 740 may perform a maneuver to guide the vehicle 100 out of a parking lot.

The parking-lot departure system 740 may receive the navigation information from the navigation system 770, may provide a control signal to the vehicle drive apparatus 600, and may perform a maneuver to guide the vehicle 100 out of the parking lot. The parking-lot departure system 740 may receive object information from the object detection device 300, may provide a control signal to the vehicle drive apparatus 600, and may perform a maneuver to guide the vehicle 100 out of the parking lot. The parking-lot departure system 740 may receive a signal from an external device through the communication device 400, may provide a control signal to the vehicle drive apparatus 600, and may perform a maneuver to guide the vehicle 100 out of the parking lot.

The parking system 750 may perform a maneuver to park the vehicle 100.

The parking system 750 may receive the navigation information from the navigation system 770, may provide a control signal to the vehicle drive apparatus 600, and may perform a maneuver to park the vehicle 100. The parking system 750 may receive object information from the object detection device 300, may provide a control signal to the vehicle drive apparatus 600, and may perform a maneuver to park the vehicle 100. The parking system 750 may receive a signal from an external device through the communication device 400, may provide a control signal to the vehicle drive apparatus 600, and may perform a maneuver to park the vehicle 100.

The navigation system 770 may provide the navigation information. The navigation information may include at least one of the following: map information, information about a preset destination, path information based on the preset destination, information about various objects on a path, lane information, or current vehicular location information.

The navigation system 770 may include a memory and a processor. The navigation information may be stored in the memory. The processor may control the operation of the navigation system 770.

According to an embodiment, the navigation system 770 may update previously stored information by receiving information from an external device through the communication device 400.

According to an embodiment, the navigation system 770 may also be classified as a sub-constituent element of the user interface device 200.

The sensing unit 120 may sense the state of the vehicle. The sensing unit 120 may include a posture sensor (e.g., a yaw sensor, a roll sensor, or a pitch sensor), a collision sensor, a wheel sensor, a speed sensor, a tilt sensor, a weight-detection sensor, a heading sensor, a yaw sensor, a gyro sensor, a position module, a vehicle forward/backward movement sensor, a battery sensor, a fuel sensor, a tire sensor, a steering sensor sensing the turning of a steering wheel, an in-vehicle temperature sensor, an in-vehicle humidity sensor, an ultrasonic sensor, an illumination sensor, an accelerator position sensor, a brake pedal position sensor, and other sensors.

The sensing unit 120 may acquire vehicular posture information, vehicular collision information, vehicular direction information, vehicular location information (GPS information), vehicular angle information, vehicular speed information, vehicular acceleration information, vehicular tilt information, vehicular forward/backward movement information, battery information, fuel information, tire information, vehicular lamp information, in-vehicle temperature information, and in-vehicle humidity information. Furthermore, the sensing unit 120 may acquire signals that result from sensing a steering wheel rotation angle, vehicle exterior illumination, pressure applied to an acceleration pedal, pressure applied to a brake pedal, and equivalents thereof.

The sensing unit 120 may further include an acceleration pedal sensor, a pressure sensor, an engine speed sensor, an air flow sensor (AFS), an air temperature sensor (ATS), a water temperature sensor (WTS), a throttle position sensor (TPS), a TDC sensor, a crank angle sensor (CAS), and other sensors.

The vehicular interface unit 130 may serve as an interface for various types of external devices connected to the vehicle 100. For example, the vehicular interface unit 130 may include a port that enables a connection to a mobile terminal and may be connected to the mobile terminal through the port. In this case, the vehicular interface unit 130 may exchange data with the mobile terminal.

The vehicular interface unit 130 may serve as an interface for supplying electrical energy to the connected mobile terminal. In a case where the mobile terminal is electrically connected to the vehicular interface unit 130, the vehicular interface unit 130 may supply electrical energy, supplied from the power supply unit 190, to the mobile terminal under the control of the control unit 170.

The memory 140 is electrically connected to the control unit 170. Basic data for the units, control data for controlling operations of the units, and input and output data may be stored in the memory 140. Examples of the memory 140 may include various hardware storage devices, such as ROM, RAM, EPROM, flash memory, and a hard disk drive. Programs and equivalents thereof for processing or control by the control unit 170 and various data for the overall operation of the vehicle 100 may be stored in the memory 140.

According to an embodiment, the memory 140 may be integrally formed with the control unit 170 or may be configured as a sub-constituent element of the control unit 170.

The control unit 170 may control the overall operation of each unit within the vehicle 100. The control unit 170 may be referred to as an Electronic Control Unit (ECU).

The power supply unit 190 may supply power necessary for the operation of each constituent element under the control of the control unit 170. Specifically, the power supply unit 190 may be supplied with power from the battery within the vehicle 100 or from other sources.

At least one processor and at least one control unit 170, which are included in the vehicle 100, may be configured based on at least one of the following: application-specific integrated circuits (ASICs), digital signal processors (DSPs), digital signal processing devices (DSPDs), programmable logic devices (PLDs), field-programmable gate arrays (FPGAs), processors, controllers, microcontrollers, microprocessors, or electric units performing other functions.

The vehicular display device 800 according to the present disclosure may form an aerial image and a real image in a plurality of different types of screen regions using a single display module. In addition, through the combination of a plurality of screen regions, a multi-display effect can be achieved using a single display module.

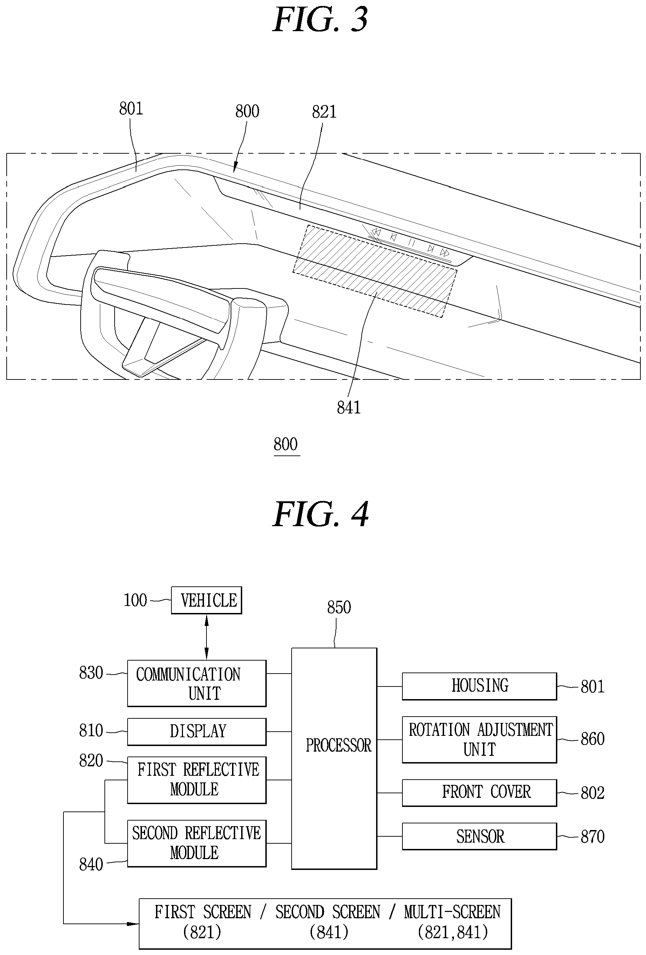

FIG. 3 is a view illustrating an example in which the vehicular display device 800 according to the present disclosure operates after installation.

The vehicular display device 800 may be installed in such a manner as to correspond to the dashboard in front of a driver's seat of the vehicle 100, or may be installed in a rectangular shape extending from the dashboard in front of the driver's seat to a front passenger seat.

The vehicular display device 800 includes a housing 801 recessed to have an inner space, and a display may be arranged on one side of the inner space of the housing 801. For example, the display of the vehicular display device 800 may be arranged in an upper portion of the inner space in the housing 801, with a front surface of the display facing downward.

The housing 801 is formed to be recessed inward to have an inner space, thereby naturally forming a dark space. Accordingly, real and virtual images may be more clearly displayed on first and second screen regions formed by first and second reflective modules 820 and 840, respectively.

The housing 801 may be formed such that the inner side of the inner space is closed and the outer side facing the driver's seat is open. In addition, the housing 801 may be formed such that the inner space decreases in width as it extends inward and increases in width as it extends outward.

A plurality of screen regions may be formed in the inner space in the housing 801 by operating the display. In an embodiment, some of the plurality of screen regions may be formed to extend outward from the housing 801.

The plurality of screen regions may include a first screen region 821 formed in the upper portion of the inner space in the housing 801 and a second screen region 841 under the first screen region 821.

The first screen region 821 is a prism screen region that is formed by a graphic displayed in a region of the display undergoing refraction through a prism, and a real image may be displayed on the first screen region 821. In addition, the second screen region 841 is a floating screen region in which a graphic displayed in another region of the display is formed after reflection through a 3D plate, and an aerial image may be output on the second screen region 841.

In the prism screen region, for example, a real image, resulting from polarized light refracted through a prism being reflected by a mirror, may be displayed above the prism. In addition, a 3D aerial image (AR) based on graphic light of the display that is reflected by the 3D plate may be displayed in the inner space of the recessed housing 801 or may be displayed with at least one portion thereof extending outward from the inner space. In the former case, the prism screen region and the floating screen region are arranged on the same plane, whereas in the latter case, these screen regions may not be arranged on the same plane.

The first screen region 821 may be formed only at a position corresponding to the driver's seat or may be formed to correspond to the driver's seat and the front passenger seat. The second screen region 841 may be formed at a position corresponding to the driver's seat and the front passenger seat.

The first screen region 821 and the second screen region 841 may be selectively formed or simultaneously formed. In a case where the first and second screen regions 821 and 841 are formed together, associated content items may be displayed as different types of images, for example, as a real image and an aerial image.

FIG. 4 is an exemplary block diagram that is referenced to describe the detailed configuration of the vehicular display device 800 according to the present disclosure.

The vehicular display device 800 may include a housing 801, a display 810, a communication unit 830, a first reflective module 820, a second reflective module 840, a processor 850, a rotation adjustment unit 860, and a sensor 870. In addition, the vehicle control device 800 may communicate with the vehicle 100 through the communication unit 830. In addition, the vehicular display device 800 may be configured to form the first screen region 821, the second screen region 841, and/or the multi-screen region indicated by 821 and 841 through the first reflective module 820 and/or the second reflective module 840.

The housing 801 constitutes a frame of the vehicular display device 800 and is formed to be recessed to form an inner space inside.

The display 810 may be arranged on one side of the inner space in the housing 801, for example, in the upper portion of the inner space. At this point, a rear surface of the display 810 is coupled to a ceiling of the inner space in the housing 801, and a front surface of the display 810 may be arranged to face the floor.

The display 810 may be arranged to be inclined at a predetermined angle in such a manner as not to be parallel to the floor. To this end, the ceiling of the inner space in the housing 801 may be formed to be inclined at a predetermined angle relative to the floor. In this manner, the display 810 is formed to be inclined at a predetermined angle relative to the floor. Thus, a floating effect of the 3D AR image displayed in the second screen region formed through the second reflective module 840 is further maximized.

The communication unit 830 may receive a vehicle state and data related to vehicle driving from the vehicle 100 in which the vehicular display device 800 is installed. In addition, the communication unit 830 may transmit an operational state of the vehicular display device 800 and data related to the operation of the vehicular display device 800 to the vehicle 100. To this end, the communication unit 830 may be configured to include both a transmission module and a reception module or to include a transceiver capable of both transmission and reception.

The first reflective module 820 may be arranged to be coupled to one side of the display 810 in the inner space in the housing 801. The first reflective module 820 may be arranged in such a manner that graphic light emitted from a first region of the display 810 undergoes refraction to form the first screen region. The first screen region refers to a prism region in which a real image of linearly polarized light is displayed, the linearly polarized light corresponding to a graphic of the display 810 that undergoes refraction through the prism. The 'first screen region' may be hereinafter referred to as a 'prism display,' a 'prism screen,' or a 'prism screen region.'

The first reflective module 820 may include a prism and a reflection plate to form the first screen region. The first screen region may be formed above the second screen region described below, and the graphic light emitted from the first region of the display 810 may be output as a real image.

The second reflective module 840 may be arranged to be coupled to one side of the first reflective module 820 in the inner space in the housing 801. The second reflective module 840 may be arranged such that graphic light emitted from the second region of the display 810 is reflected to form the second screen region. The second screen region is connected to the first screen region and defines an AR floating region in which a virtual (AR) image is displayed in the inner space in the housing 801. The 'second screen region' may be referred to as a 'floating region,' a 'floating screen,' 'a floating display,' a 'floating screen region,' an 'aerial-image screen region,' or an 'AR floating region.'

The second reflective module 840 may include a 3D plate and a reflection plate to form the second screen region. At this point, the second screen region may be formed below the first screen region. Thus, graphic light emitted from the second region of the display 810 may be output as an aerial image, that is, as a 3D AR image.

The processor 850 generally operates the display 810, the first reflective module 820, and the second reflective module 840. The processor 850 may be arranged on an inner side of the inner space in the housing 801 or on an outer side of a rear surface of the housing 801.

The processor 850 may control whether to operate the display 810 based on the startup of the vehicle or on a request. When operating the display 810, by controlling the operation of the first reflective module 820 and/or the second reflective module 840, the processor 850 may control the display 810 in such a manner that a graphic displayed on the display 810 appears as a real image or an aerial image through the first screen region and/or the second screen region.

When operating the display 810, the processor 850 may control at least one of the first and second reflective modules 820 and 840 according to a preset condition. By doing so, the processor 850 may determine whether to activate the first and second screen regions. Accordingly, an occupant in the vehicle 100 may view a graphic displayed through the display 810 at the first screen region, the second screen region, or the multi-screen region.

The processor 850 may control a change in a position of the second screen region formed through the second reflective module 840 by controlling the operation of the rotation adjustment unit 860. The rotation adjustment unit 860 may also be implemented as a function of the processor 850.

The rotation adjustment unit 860 may control the rotation of the second reflective module 840 in such a manner as to change a reflection angle and an optical path length between the second reflective module 840 and the display 810. To this end, the second reflective module 840 may be rotatably coupled to a rotation driving unit at one side of the rotation adjustment part 860.

The rotation of the second reflective module 840 may be adjusted in accordance with the operation of the rotation adjustment unit 860, thereby enabling the position of the second screen region formed through the second reflective module 840 to be varied. Accordingly, a 3D virtual image displayed in the second screen region may move backward or forward.

The rotation adjustment unit 860 may be configured to include a coupling unit for coupling to the second reflective module 860, a rotation unit for rotating the second reflective module 860, and a support unit for supporting a plate during the rotation of the second reflective module 860.

The sensor 870 may include a sensor for detecting an input to the display 810 and a sensor for detecting a (hovering) input to the first and second screen regions. In addition, the sensor 870 may further include a camera sensor, an IR sensor, an IMS sensor, and the like for recognizing an entity performing an input or monitoring a state of an occupant in the driver's seat or the front passenger seat.

In some embodiments, the sensor 870 may include a camera sensor, an IR sensor, and an IMS sensor for the vehicle. The vehicular display device 800 may recognize an occupant's field of view through the sensor 870 and may transmit information about the occupant's field of view to the processor 850. Then, the processor 850 may adjust a position where the second screen region is formed, by changing the position of the second reflective module 840 based on the occupant's field of view.

The vehicular display device 800 may further include a front cover 802. In this case, the front cover 802 may be closed to conceal the inner space in the housing 801 from being visible when the display 810 is not in operation, and may operate to expose the inner space in the housing 801 when the display 810 is in operation.

In this manner, the vehicular display device 800 according to an embodiment of the present disclosure refracts a portion of a graphic emerging from one display 810 arranged on one side of the inner space in the housing 801 through the first reflective module, and reflects another portion through the second reflective module. By doing so, the vehicular display device 800 may realize complex content, including an aerial image and a real image selectively or simultaneously, using a single display module.

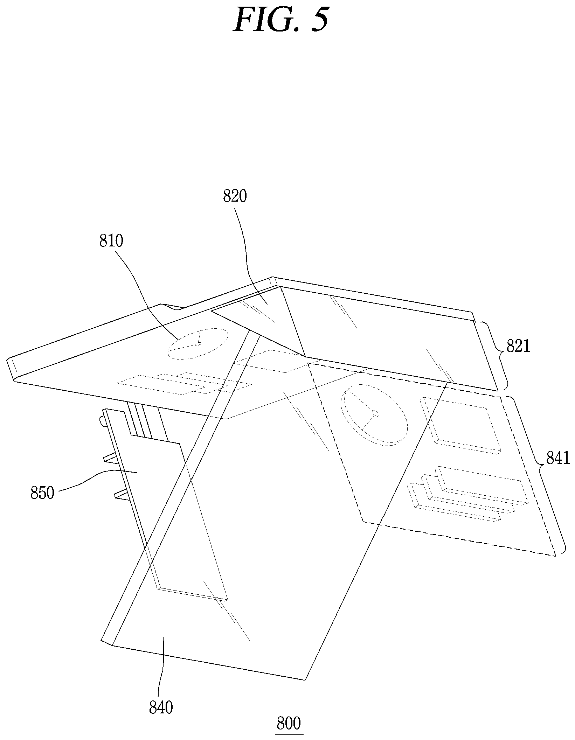

FIG. 5 is a perspective view illustrating the vehicular display device 800 according to the present disclosure. Specifically, FIG. 5 is a view illustrating one 'package' configuration of the vehicular display device 800 for outputting a graphic displayed on a single display, arranged in an upper portion, through the prism screen and the floating screen, when viewed from the side.

A display 810, inclined at a predetermined angle relative to the floor, may be arranged in an upper portion of the package. That is, the display 810 may be arranged in the upper portion in a manner tilted at a predetermined angle so as not to be parallel with the floor. Accordingly, the floating effect of the 3D virtual image displayed in the floating region formed through the second reflective module 840 described below may be expressed in a more three-dimensional and prominent manner. In addition, by arranging the front surface of display 810 to face the floor, light-emitting graphic light emerges from the front surface of display 810 in a vertical direction when the display 810 is in operation.

The processor 850, for example, a PCB, for controlling the operation of the vehicular display device 800 is arranged at the rear side of the package. The processor 850 controls the operation of the display 810, the activation and the deactivation of the first and second reflective modules 820 and 840, and the operation thereof. The processor 850 may be electrically coupled to one side of the display 810 and may be arranged to be positioned perpendicularly to the display 810 arranged in the upper portion.

The first reflective module 820 may operate to refract graphic light emerging from a region of the display 810 through a prism coupled vertically to one side of the display 810, thereby displaying a real image on the prism.

A prism of the first reflective module 820 is a refractive body fabricated from a transparent transmissive material at precise angles and planes. The prism changes an optical path by redirecting graphic light output to the first region of the display 810. The prism of the first reflective module prism 820 is arranged to be positioned perpendicularly to the display 810, and, for example, may have the shape of a triangular prism. Accordingly, the graphic light output to the first region of the display 810 is refracted, and consequently, the first screen region (or the prism region) 821 may be formed on a surface of a prism that is positioned perpendicularly to the display 810. In an embodiment, depending on the number of reflective mirrors coupled to the prism, an image of a graphic output to the first of the display 810 is either inverted or displayed in the same shape in the first screen region.

The second reflective module 840 is coupled to one side of the first reflective module 820 and includes the 3D plate arranged to be positioned at a predetermined angle relative to the display 810. The 3D plate, for example, a 3D hologram plate, may reflect graphic light emerging from another region of the display 810, for example, the second region, thereby displaying an aerial image, that is, a 3D virtual image, at a position corresponding to the occupant's field of view.

At this point, the first screen region, formed through the first reflective module 820, and the second screen region, formed through the second reflective module 840, have different depths. Specifically, the first screen region 821 is formed on a front surface of the prism of the first reflective module 820, whereas the second screen region 841 is formed in a 3D space that is formed by reflection through the 3D plate of the second reflective module 840. At this point, a portion of the second screen region may be positioned on the same plane as the first screen region.

The package may be arranged within the housing 801 (FIG. 4) recessed to form an inner space. Along with the housing structure 801, the second reflective module 840 reflects graphic light emitted from the display 810 through the 3D hologram plate, thereby forming an image at the lower end portion. This inherently obstructs external light.

Although not illustrated, the package may further include a light absorption unit for absorbing the graphic light emerging from the display 810, and a backplate coupled to a rear surface of the 3D plate of the second reflective module 840.

At this point, a material of the backplate may be an ultra-thin glass (UTG) and can perform a function of supporting the 3D hologram plate from the rear surface.

In addition, the light absorption unit is arranged to form a darkroom on the left and right sides of the housing 801 and may absorb light resulting from the graphic light emitted from the display 810 being scattered by reflection. The light absorption unit reduces the reflection luminance of the graphic light, thereby improving the contrast ratio of the 3D virtual image displayed on the second screen region 841.

The processor 850 of the package may control the second reflective module 840 in such a manner that the 3D plate thereof is rotated to change an inclination angle between the 3D plate and the display 810. The position of the 3D virtual image displayed in the second screen region 841 may be changed based on the change in the angle between the 3D plate of the second reflective module 840 and the display 810, the change being induced by the rotation of the 3D plate. To this end, one side of the second reflective module 840 is coupled to the rotation adjustment unit 860 (FIG. 4) so that the second reflective module 840 may be driven in response to a signal transmitted from the processor 850 in such a manner as to rotate the 3D plate thereof.

In some embodiments, the package may have a rotatable structure or include a driving cover such that the configuration of the package is in a closed state when the display 810 is not in operation and that at least one of the first and second screen regions 821 and 841 formed through the first and second reflective modules 820 and 840, respectively, may be exposed when the display 810 is in operation.

Subsequently, with reference to FIG. 5, the package is arranged within the housing 801 recessed to form an inner space in such a manner that the floating region formed through the second reflective module 840 may be displayed within the inner space.

In addition, as described above, a portion of the floating region that has a changed position when the 3D plate of the second reflective module 840 is rotated may be displayed outward from the inner space formed by the recess of the housing 801. Accordingly, a portion of the 3D floating content displayed in the floating region may be image-formed outward from the inner space formed by the recess of the housing 801.

The vehicular display device 800 reflects/refracts the graphic light emitted from the display 810, arranged in the upper portion, through the prism and the 3D plate that are the first and the second reflective modules 820 and 840, respectively, thereby forming a 3D aerial image and a 3D real image at the prism region 821 and the floating region 841, respectively. Consequently, the aerial image and the aerial image may be realized independently or simultaneously using a single display.

The graphic light emitted from the display 810 may be refracted through one or more lenses and prisms to form an eye box. To this end, an incident optical module for forming a curvature and an optical path may be further included. For example, a lens and a prism may be arranged at a predetermined angle (e.g., a right angle) relative to the display so as to have a curvature and an optical path for forming an eye box for a graphic displayed in the first region of the display 810.

In addition, the graphic light emitted from the display 810 may be reflected through the 3D plate and the reflective mirror, thereby forming an eye box for displaying an aerial image. At this point, the combiner for compensating for chromatic aberration and adjusting a focal length may be coupled. The combiner may include a 3D plate, which serves to reflect the emitted graphic light refracted through the prism, and a reflective mirror. An example of the 3D plate is a 3D hologram plate.

At this point, the reflective mirror may be configured in the form of a flat plate or a film. A reflective surface of the reflective mirror is formed on a portion of a front surface of the 3D plate, the portion facing the user's eyes, thereby compensating for the chromatic aberration and adjusting the focal length. In addition, according to the present disclosure, since the graphic light of the display 810 arranged in the upper portion of the package is emitted to the 3D plate either after being refracted through the prism or directly, the chromatic aberration due to the separation of a wavelength hardly occurs.

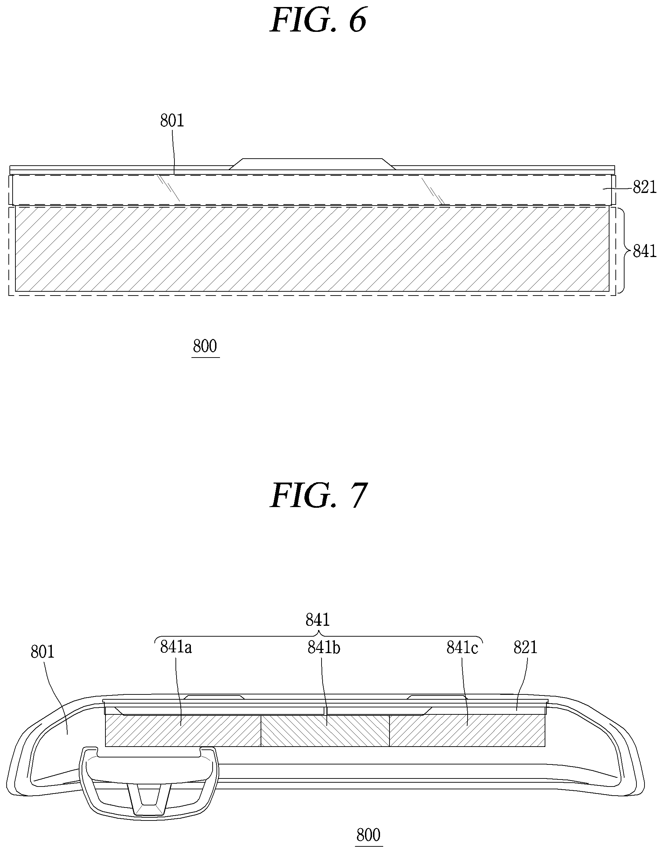

FIG. 6 is a view illustrating a state where the prism display region 821 and the floating display region 841 are formed when the vehicular display device 800 is in operation, when viewed from the side.

As illustrated in FIG. 6, the prism display region 821 may be formed in the upper portion of the inner space formed by the recess of the housing 801, and the floating display region 841 may be formed in the lower portion of the inner space formed by the recess of the housing 801.

The floating display region 841 may be formed to have a greater size than the prism display region 821. A real image may be displayed on the prism display region 821, and an aerial image having depth, that is, a 3D AR image, may be displayed on the floating display region 841.

The prism display region 821 and the floating display region 841 may be used selectively or may operate simultaneously.

To this end, when operating the display 810, the processor 850 of the vehicular display device 800 may control the operation of at least one of the first and second reflective modules 820 and 840 according to a preset condition. By doing so, the processor 850 may determine whether to activate the first and second screen regions, that is, the display region 821 and the floating display region 841.

At this point, the predetermined condition is associated with a driving state of the vehicle 100 in which the vehicular display device 800 is installed. For example, the predetermined conditions may correspond to various situations where a warning or alarm is required based on the driving state of the vehicle.

The processor 850 may activate the first reflective module 820 based on information related to the vehicle driving state, the information being received through the communication unit 830, while the vehicle is in a first driving state, thereby displaying a vehicle driving situation in the prism display region 821.

At this point, the first driving state refers to a normal driving state after vehicle ignition, representing a general driving situation where no warning or alarm is required.

Subsequently, when the vehicle transitions from the first driving state to a second driving state according to the information related to the vehicle driving state, the information being received through the communication unit 830, the first and second reflective modules 820 and 840 may be both activated. By doing so, the first and second reflective modules 820 and 840 may be controlled in such a manner that the vehicle driving situation is displayed together in the prism display region 821 and the AR floating display region 840.

At this point, the second driving state refers to a state where a driving situation, requiring a warning or alarm, occurs during vehicle driving. For example, the processor 850 may initiate a transition to the second driving state in a case where a warning or alarm is necessary due to the vehicle's regulation speed violation, a sharp curve ahead, or the appearance of an object around the vehicle. Furthermore, when the situation is cleared, the processor 850 may initiate a transition back to the first driving state.

In addition, according to the information related to the vehicle driving vehicle state, the information being received through the communication unit 830, the second reflective module 840 may be activated while the vehicle 100 is in a third driving state. By doing so, the second reflective module 840 may be controlled in such a manner that the AR virtual image is displayed in the AR floating display region 840 and that a graphic object related to the AR virtual image is displayed in the prism display region 821.

At this point, the third driving state may refer to a state where an entertainment function is performed while the vehicle is in a stopped state.

In another embodiment, the processor 850 of the vehicular display device 800 may determine to display one or both of the prism display region 821 and the AR floating display region 840, depending on the type of content to be output to the display 810. For example, the type of content related to a state of the vehicle may be displayed on the prism display region 821, and the type of entertainment content may be displayed in the AR floating display region 840.

In addition, in another embodiment, the processor 850 of the vehicular display device 800 may determine to display one or both of the prism display region 821 and the AR floating display region 840 based on the user's input or request.

As described above, the vehicular display device 800 according to the embodiment of the present disclosure may selectively provide a usage environment of a plurality of displays using a single display.

FIG. 7 is an exemplary view that is referenced to describe a plurality of display regions in accordance with a display mode of the vehicular display device 800.

According to a preset condition, the vehicular display device 800 may operate in a 'prism display mode' to display a real image in the prism screen region, may operate in a 'floating display mode' to display an aerial image in the floating screen region, or may operate in a 'multi-display mode' to simultaneously display a real image and an aerial image in the prism screen region and the floating screen region, respectively.

At this point, as described above, the preset condition may be related to the driving state of the vehicle, may be associated with the type of content to be image-formed, or may correspond to the user's input or request.

The vehicular display device 800 may control the second reflective module 840 in such a manner that the floating screen region 841 formed through the second reflective module 840 is displayed, in the inner space formed by the recess of the housing 801, at a position corresponding to each of the driver's seat and the front passenger seat.

Specifically, with reference to FIG. 7, the floating screen region 841 may be divided into a first floating region 841a, positioned to correspond to the driver's seat, a third floating region 841c, positioned to correspond to the front passenger seat, and a second floating region 841b, positioned to correspond to the space between the driver's seat and the front passenger seat.

The first floating region 841a may be a region used by an occupant in the driver's seat, and the third floating region 841c may be a display region used by the occupant in the front passenger seat. In addition, the second floating region 841b may be a display region commonly used by the occupants in the driver's seat and the front passenger seat.

A 3D AR image that floats to correspond to the occupant's field of view in the driver's seat is displayed in the first floating region 841a. In addition, a 3D AR image that floats to correspond to the occupant's field of view in the front passenger seat is displayed in the third floating region 841c. In addition, a 3D AR image that floats to correspond to a preset field of view, for example, a field of view preset to correspond to the driver's seat or to correspond to the front passenger seat, is displayed in the second floating region 841b.

Content items, displayed in the first, second, and third floating regions 841a, 841b, and 841c, respectively, may be controlled independently for display.

In addition, a switchable privacy mode (SPM) may be executed in such a manner that the first floating region 841a is not visible from the front passenger seat and that content displayed in the third floating region 841c is not visible from the driver's seat. At this point, 3D content may be displayed in the second floating region 841b within a field of view visible from both the driver's seat and the front passenger seat.

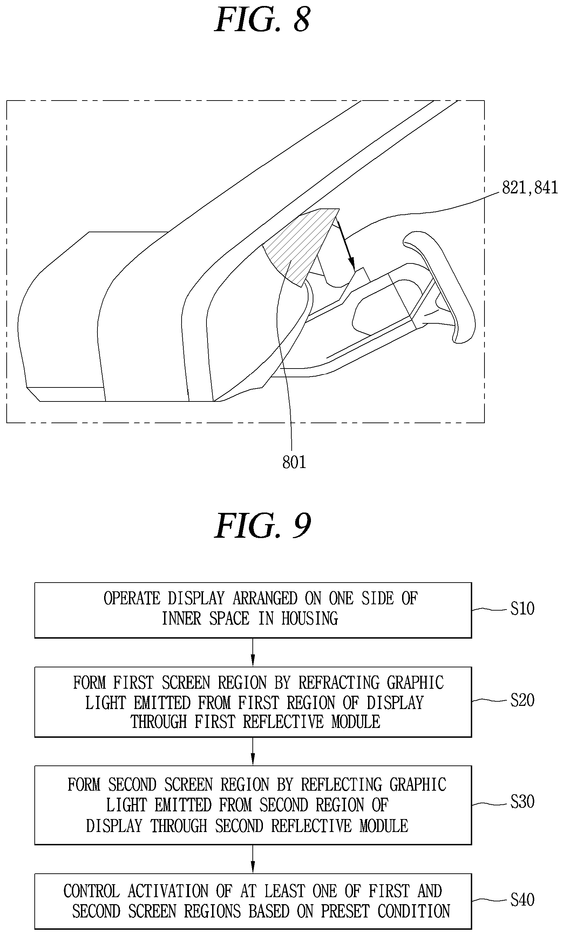

FIG. 8 is a view illustrating the vehicular display device 800 arranged in a cluster or CID region of the vehicle 100 according to the present disclosure, when viewed from the side. As illustrated in FIG. 8, the housing 801 of the vehicular display device may be arranged at a position corresponding to the dashboard in front of the driver's seat. The housing 801, for example, may be formed to be recessed inward to have an inner space in such a manner as to have a volume of approximately 23 liters.

Although not illustrated in detail, when the vehicular display device 800 is in operation, the prism display region 821 in which a real image is displayed, and the floating display region 841 in which an aerial image, that is, a 3D AR image, is displayed may be formed in the inner space in the housing 801 that is exposed within the occupant's field of view, thereby providing an eye box for the user.

When the vehicular display device 800 is not in operation, the housing 801 may be rotated or covered by the front cover so that the inner space of housing 801 is hidden from view.

The vehicular display device 800 may selectively activate the prism display region 821 and the floating display region 841 to direct the graphic light emitted from the display 810, which is arranged in the upper portion of the inner space in the housing 801, toward the user's field of view.

To this end, the vehicular display device 800 may control the display 810 in such a manner that the graphic light emitted from the first region of the display 810 is retracted through the prism and thus that a real image is displayed on the surface of the prism.

In addition, the vehicular display device 800 may control the display 810 in such a manner that the graphic light emitted from the second region of the display 810 is retracted through the prism, reflected by the 3D plate, and passes through a reflective polarized plate and/or an absorption-type polarized plate, and thus that a 3D AR image is displayed in the inner space in the housing 801 that matches the eye level of the user.

FIG. 9 is an exemplary flowchart that is referenced to describe a method of operating the vehicular display device 800 according to the present disclosure.

With reference to FIG. 9, the method of operating the vehicular display device 800 according to the embodiment of the present disclosure starts with a step of operating the display arranged on one side of the inner space in the housing 801 (FIG. 4) (S10). Graphic light is emitted from the front surface when the display 810 is in operation.

To this end, the display 810 of the vehicular display device 800 may be arranged in an upper inner portion of the inner space in the housing 801 in such a manner that the front surface thereof faces toward the ground, but may be formed to have a structure configured with a slope non-parallel with the ground.

In this manner, the display 810 is arranged in the upper inner portion of the inner space in the housing 801, thereby enabling the emitted graphic light to have a curvature and an optical path for forming an eye box. Accordingly, the optical path is formed in such a manner that the graphic light emitted from the display 810 is directed toward the 3D plate of the second reflective module 840 without being dispersed.

In addition, since the display 810 to be arranged in the upper portion is formed to have a structure inclined instead of being parallel to the ground, the floating effect of the 3D AR image appearing in the floating display region 841 formed through the second reflective module 840 is maximized.

Subsequently, the vehicular display device 800 may operate such that the graphic light emitted from the first region of the display 810 is reflected by the first reflective module 820, thereby forming the first screen region (S20).

In addition, the vehicular display device 800 may operate such that the graphic light emitted from the second region of the display 810 is reflected by the second reflective module 840, thereby forming the second screen region (S30).

In this manner, the formation of the first and second screen regions may indicate that image formation of the graphic light, emitted by operating the display 810, in any one of the first and second screen regions is completely prepared.

In this manner, when image formation in one or all of a plurality of screen regions is completely prepared, depending on whether a preset condition is satisfied, the display device 800 may control the first and second reflective modules 820 and 840 in such a manner that at least one of the first and the second screen regions formed through the first and second reflective modules 820 and 840 is activated (S40).

Specifically, for example, the first screen region formed through the first reflective module 820 may be activated to display only the vehicle driving state, thereby displaying a real image on the surface of the prism. In addition, for example, the second screen region formed through the second reflective module 840 may be activated to display a warning or alarm or to provide guidance on a hazardous situation, thereby displaying the floating 3D AR image in the inner space formed by the recess of the housing 801. At this point, the inner space formed by the recess of the side-closed housing 801 may naturally provide a darkroom effect, thereby display the floating 3D AR image more clearly.

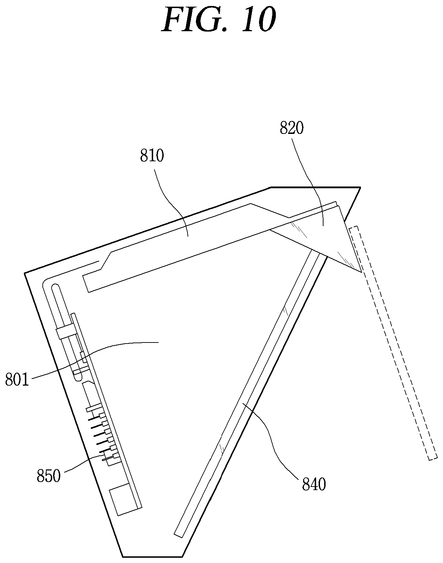

FIGS. 10, 11, and 12 are views illustrating exemplary structures of the vehicular display device 100, respectively, for executing a plurality of display modes using a single display, according to an embodiment of the present disclosure.

FIG. 10 illustrates a basic structure of the housing 801 of the vehicular display device 800. In the basic structure, the display 810 may be arranged in the upper portion of the inner space formed by the recess of the housing 801, and the processor 850 may be arranged in a rear portion of the inner space. In addition, the first reflective module 820, which is coupled to one side of the display 810 and includes the prism, is arranged to be perpendicular to the display 810 so as to align with the perpendicular direction in which light is emitted from the display 810. In addition, the second reflective module 840, which is coupled to one side of the first reflective module 820 and by which light that is refracted while passing through the prism of the first reflective module 820 is reflected, may be arranged to form a predetermined angle relative to the display 810. At this point, the second reflective module 840 may be formed to include a 3D hologram plate and a reflective mirror (not illustrated) that are arranged in the inner space in the housing 801 and formed to face the front surface of the display 810.

In an embodiment, in a state where the first reflective module 820 is activated, the processor 850 may control the first reflective module 820 in such a manner that the prism thereof refracts linearly polarized light corresponding to a graphic, the linearly polarized light being emitted from the first region of the display 810, thereby forming the first screen region.

In addition, in a state where the second reflective module 840 is activated, the processor 850 may control the second reflective module 840 in such a manner that the 3D plate thereof reflects the graphic light emitted from the second region of the display 810 or the linearly polarized light refracted through the prism, thereby forming the second region in which the 3D virtual (AR) image is displayed.

The first screen region formed through the first reflective module 820 is configured to extend over the second screen region formed through the second reflective module 840 and to the first region of the display 810.

In addition, the second screen region formed through the second reflective module 840 is formed below the first screen region formed through the first reflective module 820. 3D AR content displayed in the second screen region may be formed only within the inner space of housing 801, or a portion thereof may be formed to extend outward from the inner space.

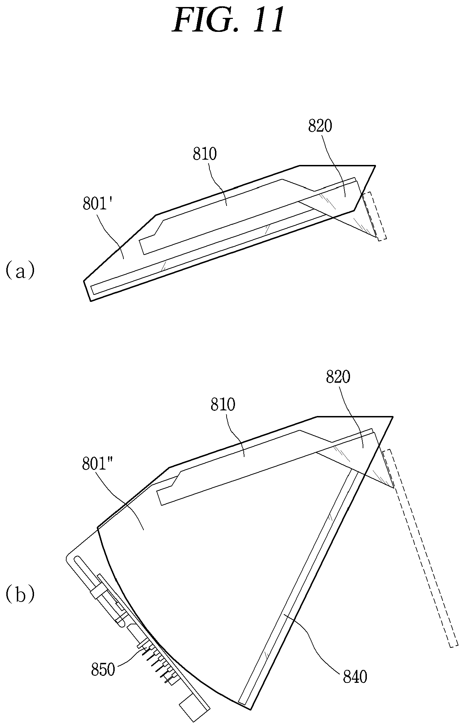

(a) of FIG. 11 illustrates an exemplary structure used only in the first screen region that is formed through the prism of the first reflective module 820 when the display 810 of the vehicular display device 800 operates. The volume of a housing 801' may be minimized in a state where, as illustrated in (a) of FIG. 11, the 3D hologram plate is folded or rotated in parallel with the display 810. The structure of the housing 801' may be referred to as a minimum slim package, and the graphic light emitted from the display 810 is refracted through the prism and is displayed as a real image on the front surface thereof. For example, in a case where the 3D hologram plate of the second reflective module is rotated, and thus an inner space in the housing 801' is reduced to the minimum, the volume of the minimum slim package may change to 9 liters.

(b) of FIG. 11 illustrates a state where the first and second reflective modules 820 and 840 are both in operation when the display 810 of the vehicular display device 800 operates and where the first and second screen regions are correspondingly activated. At this point, the processor 850 may be arranged on an outer rear portion of the housing 801'' in such a manner as to be coupled to one side of the display 810.

In addition, according to an embodiment, a UTG plate may be coupled to the front surface of the 3D plate of the second reflective module 840, thereby forming an optical path for an eye box. In addition, although not illustrated, the vehicular display device 800 may further a light absorption plate adjacent to the 3D plate of the second reflective 840 and additionally absorbing linearly polarized light that is not reflected by the 3D plate.

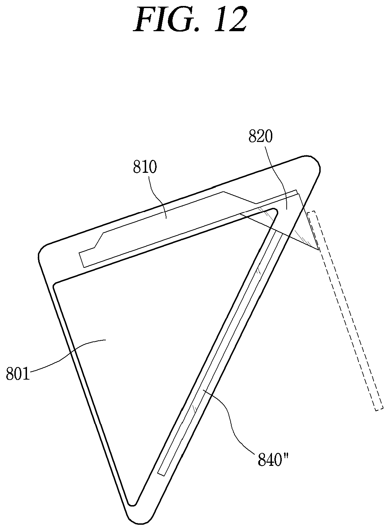

Subsequently, with reference to FIG. 12, the package of the vehicular display device 800 may be formed on the dashboard in a manner integrated with an air duct of the driver's seat of the vehicle 100, thereby having a slimmed structure. In this manner, in a case where the package is modularized with an air purifier of the vehicle, the package and the housing may be configured to have a volume of 11 liters, which is somewhat greater than the volume of the above-described minimum slim package.

As described above, in the embodiments, the vehicular display device 800 according to the embodiment of the present disclosure has the structures in which different types of graphics are displayed in the plurality of display regions using a single display.

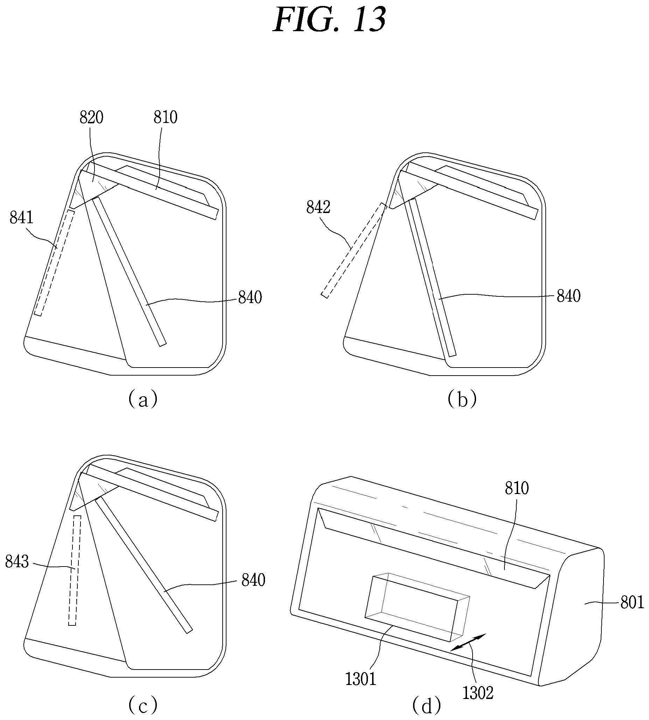

Subsequently, with reference to FIG. 13, a method of changing a position of an AR image displayed in the floating display region in the vehicular display device 800 according to the present disclosure is described in detail below.

A real image may be displayed on the surface of the prism in the first screen region formed through the first reflective module 820, and a 3D virtual (AR) image having a depth may be displayed in the second screen region formed through the second reflective module 840.

In an embodiment of the present disclosure, the 3D virtual (AR) image to be displayed in the second screen region may be displayed while moving along the X-axis, Y-axis, and Z-axis directions in the inner space in the housing 801. To this end, the 3D hologram plate of the second reflective module 840 is configured to be rotatable to adjust an inclination angle between the 3D hologram plate and the display 810.

Specifically, as illustrated in FIG. 13, the first reflective module 820 is fixed to one side of the display 810, and the second reflective module 840 is arranged to have a rotatable structure within the inner space in the housing 801. One side of the second reflective module 840 is fixed to be adjacent to the first reflective module 820. The second reflective module 840 is formed in such a manner that a separation distance from the display 810 progressively increases from one side toward the other side thereof. In addition, the second reflective module 840 is configured to allow the inclination angle between the second reflective module 840 and the display 810 to be adjustable by the operation of the rotation adjustment unit 860.

The processor 850 of the vehicular display device 800 may transmit a signal for adjusting the rotation of the second reflective module 840 to the rotation adjustment unit 860 in such a manner as to adjust the inclination angle between the second reflective module 840 and the display 810.

The rotation control unit 860 may include a coupling unit coupled to one side of the 3D plate of the second reflective module 840, a drive unit providing a driving force for rotating the 3D plate, and a support unit supporting the 3D plate while the 3D plate is rotated.

When the rotation control unit 860 operates in response to a driving signal transmitted from the processor 850, the 3D plate of the second reflective module 840 may rotate by a predetermined angle in a clockwise or counter-clockwise direction based on information included in the driving signal.

(a) of FIG. 13 is an exemplary view illustrating the default basic position of the second reflective module 840 in the inner space in the housing 801. In a case where the 3D plate of the second reflective module 840 is arranged at the predetermined default position, the second screen region 841, where the 3D AR content is displayed, may be displayed, for example, at an opening of the inner space in the housing 801.

In an embodiment, the processor 850 can adjust the rotation of the second reflective module 840 through the rotation control unit 860, thereby adjusting the inclination angle between the display 810 and the 3D plate. By doing so, the second screen region 841 in which the 3D AR content is displayed may be controlled in such a manner that a position thereof moves backward or forward with respect to the inner space in the housing 801.

(b) of FIG. 13 is a view illustrating an example in which the 3D plate of the second reflective module 840 rotates clockwise by a predetermined angle from the default position thereof, thereby further increasing the inclination angle between the display 810 and the 3D plate.

In this manner, when the magnitude of the inclination angle between the display 810 and the 3D plate of the second reflective module 840 increases, the position of the second screen region 841 formed through the second reflective module 840, that is, the position of the floating display region, protrudes forward. Accordingly, at least one portion of the 3D AR image to be displayed in the second screen region 841 may be displayed outward from the inner space in the housing 801.

(c) of FIG. 13 is a view illustrating an example in which the 3D plate of the second reflective module 840 rotates counterclockwise by a predetermined angle from the default position thereof, thereby further decreasing the inclination angle between the display 810 and the 3D plate.

In this manner, when the magnitude of the inclination angle between the display 810 and the 3D plate of the second reflective module 840 decreases, the position of the second screen region 841 formed through the second reflective module 840, that is, the position of the floating display region, is pushed backward, thereby displaying the second screen region 841. Accordingly, the 3D AR image to be displayed in the 2-second screen region 841 may be displayed further inside the inner space in the housing 801.

(d) of FIG. 13 is a view illustrating a state where, when the 3D plate of the second reflective module 840 rotates, a 3D AR image 1301 displayed in the second screen region, that is, in the floating display region 841, moves in a backward-forward direction 1302 in the inner space in the housing 801. At this point, a graphic displayed in the first screen region formed through the first reflective module 820, that is, in the prism display region, remains displayed on the same plane.

In this manner, the 3D AR image may move under various conditions when the position of the 3D plate of the second reflective module 840 changes.

In an embodiment, the processor 850 of the vehicular display device 800 may adjust the rotation of the second reflective module 840 in such a manner as to vary the position of the second screen region. This adjustment is based on field-of-view information (i.e., an eye box or eye level) of an occupant detected by an IMS or DMS sensor of the vehicle 100, the field-of-view information being received from the vehicle 100. To this end, the processor 850 may calculate refraction, curvature, and optical path corresponding to the field-of-view information of the occupant detected through the IMS or DMS sensor. By doing so, when operating the display 810, the processor 850 may adjust the position of the 3D plate of the second reflective module 840.

In addition, in an embodiment, when operating the display 810, the processor 850 of the vehicular display device 800 may activate the first and second screen regions formed through the first and second reflective modules 820 and 840, respectively. Subsequently, the processor 850 may display a first graphic image, which is a real image, in the first screen region 821, that is, in the prism display region. Based on the movement of a second graphic image, which is an aerial (virtual) image, displayed in the second screen region 841, that is, in the floating display region, the processor 850 may adjust the rotation of the second reflective module 840 in such a manner as to adaptively vary the position of the floating display region.

For example, in a case where the 3D AR image displayed in the floating display region is of a 3D content type configured to move backward or forward, the 3D plate of the second reflective module 840 may rotate in a manner that corresponds to such a movement pattern. Accordingly, the 3D virtual (AR) image, as illustrated in (d) of FIG. 13, may operate in such a manner as to move backward or forward with respect to the inner space formed by the recess of the housing 801. To this end, the 3D plate of the second reflective module 840 may operate in such a manner as to rotate according to a pattern preset on a per-content basis.

In addition, for example, in the case of content that is effective when the 3D (AR) virtual image is displayed in such a manner as to protrude toward the driver, the position may be changed in the direction of increasing the inclination angle between the 3D plate of the second reflective module 840 and the display 810. Conversely, in the case of content that is effective when the 3D (AR) virtual image is displayed in such a manner as to be introduced into the housing 801, the position may be changed in the direction of decreasing the inclination angle between the 3D plate of the second reflective module 840 and the display 810. For example, the 3D virtual (AR) image of the second reflective module 840 may rotate clockwise or counterclockwise to create an effect where the 3D virtual (AR) image appears to be zoomed in or out. Alternatively, the 3D plate of the second reflective module 840 may be maintained in a fixed state, and the housing, including the package, may rotate in a specific direction, thereby achieving the same or similar effect.

The above-mentioned package may be configured to have a structure that is rotatable together with the dashboard of the vehicle 100. In this case, the inner space formed by the recess of the housing 801 may be exposed or closed in response to the rotation of the package. As another example, the housing 801 may further include a front cover for closing the inner space formed by the recess of the housing 801.

A vehicular display device having another structure, which is capable of providing complex content through different types of displays using one display module, is described below.

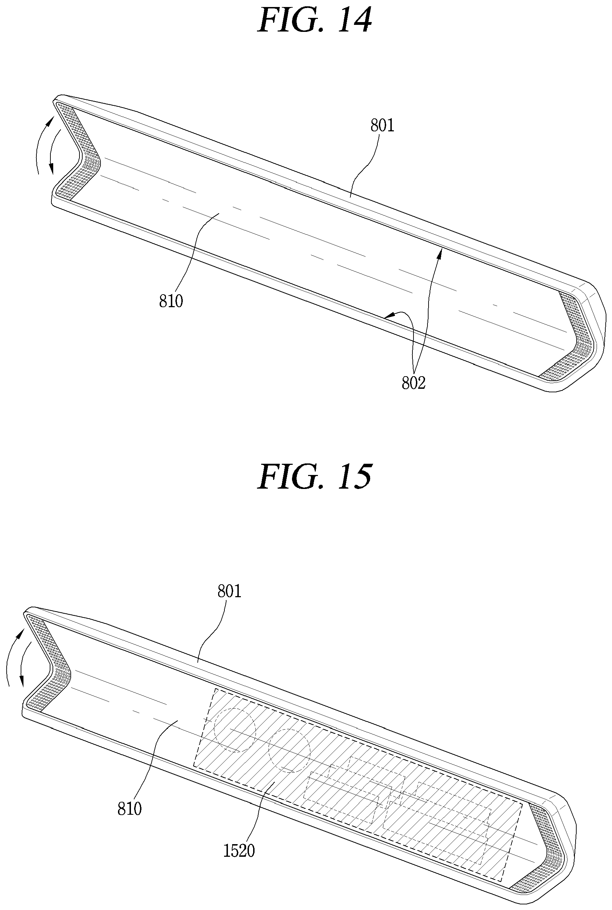

FIG. 14 is a view illustrating a vehicular display device according to another embodiment of the present disclosure.

In addition, FIGS. 15 to 17 are exemplary conceptual views that are referenced to describe the operation of the vehicular display device according to the embodiment of the present disclosure, which includes a floating display region and a variable display region.

With reference to FIG. 14, the vehicular display device according to the embodiment of the present disclosure may be configured to have a structure in which the inner space is formed by the recess of the housing 801, and the display 810 may be arranged throughout the entire inner space formed by the recess of the housing 801.

As upper and lower frames approach each other, the front cover 802 of the housing 801 closes the inner space in the housing 801. As the upper and lower frames recede away from each other, the inner space in the housing 801 is exposed to the outside.

When the display 810 is in operation, the graphic light emitted from the display 810 may be reflected by the 3D plate, thereby forming the floating display region on the same plane as the front cover 802 of the housing 801. To this end, the vehicular display device 800 may include a reflective module coupled adjacent to the display 810 and arranged in such a manner that the graphic light emitted from the display 810 is reflected by the reflective module, thereby forming a virtual screen module within the inner space. FIG. 15 illustrates the formation of a floating display region 1520 in which the 3D virtual (AR) image floats, resulting from the graphic light emitted from one region of the display 810 being reflected upward and downward.

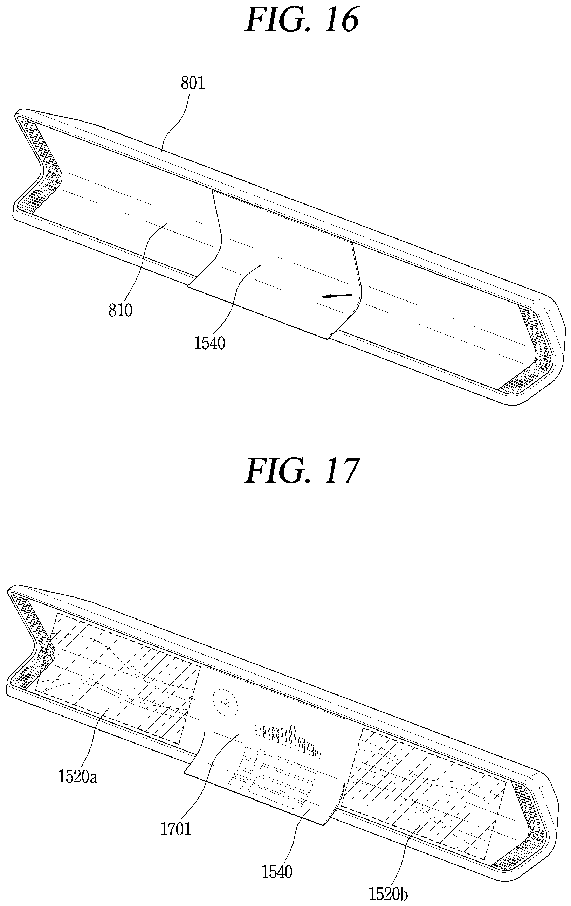

As illustrated in FIG. 16, in the vehicular display device, a specific region 1540 of the display 810 can be bent out. At this point, the specific region 1540 may be a central region of the display 810 that corresponds to the CID region of the vehicle 100.

To drive the specific area 1540 that is bent out, the vehicular display device 800 may include a drive module arranged on a rear surface of one region of the display 810 in such a manner that one portion of the display 810 is bent out, thereby forming a form-variable display region. In this case, the processor coupled to the rear surface of the housing 801 may transmit a control signal to the drive module, thereby enabling the drive module to bend out or bend in the specific region 1540 in response to the control signal.

FIG. 17 is a view illustrating that a left-side region and a right-side region of the display 810 are configured as the floating display region and that a central region thereof is configured as the form-variable display region that is bent out.

In this structure of the vehicular display device, when operating the display 810, the processor may control the operation of at least one of the following: the 'reflective module,' forming the floating region according to a preset condition, or the 'drive module,' forming the form-variable display region. By doing so, the processor QQ810 may determine whether to activate the flowing screen region and the form-variable display region.

For example, when the form-variable display region is in a deactivated state, the floating region and the form-variable display region may be displayed on different surfaces, respectively. That is, a graphic image may be displayed on the central region of the display 810 in a recessed state.

In addition, for example, when the form-variable display region is in an activated state, the floating region and the form-variable display region may be displayed on the same plane.

In addition, for example, in a state where the form-variable display region is activated, as illustrated in FIG. 17, even when a form-variable display region 1540 is bent out, a graphic image 1701 may be displayed on first and second floating regions 1520a and 1520b on the left side and right side, respectively, of the display that are not on the same plane. This configuration is intended to enable the user to easily operate the form-variable display region 1540 without changing the user's posture.

When a user input is not provided for a predetermined time or when the ignition of the vehicle 100 is off, the bent-out form-variable display region 1540 may be bent in, thereby restoring the display 810 to the original state thereof.

As described above, in the vehicular display device according to the embodiment of the present disclosure, and the method of operating the vehicular display device, a plurality of different display modes may be executed selectively or simultaneously using a single display module. For example, a real image or an aerial image may be displayed selectively or simultaneously using only a single display. In addition, the position of the floating 3D virtual image that floats according to the type or movement of content is varied, thereby matching the user's field of view and displaying a graphic image to maximize the user's immersion and the floating effect.

The present disclosure may be implemented in the form of computer-readable code recorded on a program-recorded medium. Computer-readable media include all types of recording devices capable of storing data that are readable by a computer system. Examples of computer-readable media include hard disk drives (HDDs), solid-state disks (SSDs), silicon disk drives (SDDs), ROM, RAM, CD-ROM, magnetic tapes, floppy disks, optical data storage devices, and other similar media. In addition, these media may further include transmission media, such as waves (e.g., waves transmitted over the Internet). In addition, the computer may also include a processor of the vehicular display device 800. Therefore, the detailed description should not be construed as limiting in any respect, but should be regarded as illustrative in nature. The scope of the present disclosure should be determined by the proper interpretation of the following claims. All equivalent modifications to the embodiments of the present disclosure fall within the scope of the present disclosure.

## Claims

1. A vehicular display device comprising:
a housing recessed to form an inner space inside;
a display arranged on one side of the inner space in the housing;
a first reflective module coupled to one side of the display in the inner space and arranged in such a manner that graphic light emitted from a first region of the display forms a first screen region after refraction;
a second reflective module coupled to one side of the first reflective module in the inner space and arranged in such a manner that graphic light emitted from a second region of the display forms a second screen region after reflection; and
a processor arranged on the other side of the inner space and coupled to the display, the first reflective module, and the second reflective module, thereby controlling each operation thereof,
wherein, when operating the display, the processor controls the operation of at least one of the first and second reflective modules according to a preset condition, thereby determining whether to activate the first and second screen regions.

2. The vehicular display device of claim 1, wherein the first screen region is a prism region, and the second region is an AR floating region that is connected to the first screen region and in which an AR image is displayed in the inner space.

3. The vehicular display device of claim 2, wherein the preset condition is associated with a vehicle driving state,
wherein the processor receives, from the vehicle, information related to the vehicle driving state and activates the first reflective module according to the received information while a vehicle is in a first driving state, thereby displaying a driving situation on the prism region, and
wherein, when the vehicle switches to a second driving state according to the received information, the processor controls the first and second reflective modules by activating both the first and second reflective modules in such a manner that the driving situation is displayed together in the prism region and the AR floating region.

4. The vehicular display device of claim 3, wherein the processor activates the second reflective module according to the received information while the vehicle is in a third driving state, and controls the second reflective module in such a manner that a virtual image is displayed in the second screen region and that a graphic object related to the virtual image is displayed in the first screen region.

5. The vehicular display device of claim 1, wherein the display is arranged in an upper inner portion of the inner space in the housing in such a manner as to face the ground and is formed to have a structure configured with a slope non-parallel with the ground.

6. The vehicular display device of claim 1, wherein the first reflective module includes a prism arranged in an upper portion in such a manner as to extend to the first region of the display,
wherein the second reflective module includes a 3D plate that extends from one side of the prism and is arranged to face the second region of the display, and
wherein, in a state where the first reflective module is activated, the processor controls the prism in such a manner as to refract linearly polarized light corresponding to a graphic on the first region, thereby forming the first screen region, and, in a state where the second reflective module is activated, the processor controls the 3D plate in such a manner as to reflect linearly polarized light corresponding to a graphic on the second region, thereby forming the second screen region in which a 3D virtual (AR) image is displayed.

7. The vehicular display device of claim 6, wherein the first screen region is formed over the second screen region in such a manner as to extend to the first region of the display, and
wherein the second screen region is formed under the first screen region, and AR content to be displayed in the second screen region is formed within the inner space in the housing or is formed to extend outward from the inner space.

8. The vehicular display device of claim 6, further comprising:
a UTG plate coupled to a rear surface of the 3D plate; and
a light absorption plate adjacent to the 3D plate and absorbing linearly polarized light that is not reflected by the 3D plate.

9. The vehicular display device of claim 1, wherein the first reflective module is fixed to be adjacent to the first region of the display,
wherein one side of the second reflective module is fixed to be adjacent to the first reflective module and is formed in such a manner that a separation distance from the display progressively increases from one side toward the other side thereof and that an inclination angle between the second reflective module and the display is adjustable, and
wherein the processor is arranged on a rear surface of the inner space in the housing and adjusts the rotation of the second reflective module in such a manner that the inclination angle between the second reflective module and the display is adjusted.

10. The vehicular display device of claim 9, wherein the processor adjusts the rotation of the second reflective module, thereby adjusting the inclination angle, and thus controls the second screen region in such a manner that a position thereof moves backward or forward with respect to the inner space in the housing.

11. The vehicular display device of claim 10, wherein the processor adjusts the rotation of the second reflective module based on field-of-view information of an occupant detected by an IMS sensor of a vehicle in such a manner that the position of the second screen region is varied.

12. The vehicular display device of claim 11, wherein the processor displays a first graphic image in the first screen region through the first reflective module, and, based on movement of a virtual second graphic image displayed in the first screen region through the second reflective module, adjusts the rotation of the second reflective module in such a manner that the position of the second screen region is adaptively varied.

13. The vehicular display device of claim 1, wherein the housing further comprises:
a front cover formed in such a manner that the inner space, formed by recessing the housing, is rotatable, and driven according to whether the display is in operation, in such a manner that the inner space is closed or exposed.

14. A vehicular display device comprising:
a housing recessed to form an inner space inside;
a display positioned in an inner space in the housing;
a reflective module coupled adjacent to the display and arranged in such a manner that graphic light emitted from the display forms a virtual screen region within the inner space after refraction;
a drive module arranged on a rear surface of one region of the display in such a manner that one portion of the display is bent out, thereby forming a form-variable display region; and
a processor electrically connected to the display, the reflective module, and the drive module and controlling each operation thereof,
wherein, when operating the display, the processor controls the operation of at least one of the reflective and drive modules according to a preset condition, thereby determining whether to activate the virtual screen region and the form-variable display region.
